# EUROPEAN PATENT SPECIFICATION

(11) **EP 0 332 274 B1**
(45) Date of publication and mention of the grant of the patent: **22.06.1994**
(21) Application number: 89200552.1
(22) Date of filing: 06.03.1989
(51) Int. Cl.: G11C 16/06

(54) **EEPROM having a data controlled erasing and writing mode**
EEPROM mit durch Daten gesteuerten Löschungs- und Schreibmodus
EEPROM à mode d'effacement et d'écriture commandé par des données

(30) Priority: 09.03.1988 NL 8800583
(43) Date of publication of application: 13.09.1989
(73) Proprietor: Philips Electronics N.V., 5621 BA Eindhoven (NL); FASELEC A.G., CH-8045 Zürich (CH)
(72) Inventor: Feller, Ernst, NL-5656 AA Eindhoven (NL)
(74) Representative: Strijland, Wilfred

(56) References cited:
- EP-A- 0 131 344
- US-A- 3 938 108
- US-A- 4 442 510
- PATENT ABSTRACTS OF JAPAN vol. 7, no. 82 (P-189)(1227) April 6, 1983& JP-A-58 9 271

## Description

The invention relates to an integrated memory circuit comprising an EEROM having a data controlled erasing and writing mode EP-A-0 131 344 discloses an integrated circuit with a byte organized EEPROM. The EEPROM has a plurality of memory cells arranged in rows and columns. The columns are organized in a plurality of sections. The bit cells associated with a single byte are distributed over the sections such that a respective bit cell of the byte is located in a column of a respective section. Each section individually has a writing circuit. The writing circuits can be activated independently form one another depending on whether or not the cell to be written stores the same logic level as of the bit signal that one intends to write into the cell. EP-A-0 131 344 discloses all the features of the preamble of claim 1.

A memory circuit is known from the international PCT-publication WO 83/01148. In this memory circuit a plurality of columns is coupled to the memory data input via column selection gates. Each memory location comprises a plurality of bit cells. Each bit cell is connected between a bit line and a voltage terminal and comprises a series arrangement of a conduction channel of a selection transistor and a conduction channel of a programmable transistor having a floating gate. The voltage terminal is common to all bit cells in the memory and serves to feed a first supply voltage to each bit cell in an erase mode of the memory and to feed a second supply voltage to each bit cell in a program mode of the memory. In the program mode one memory location at a time can be programmed because of the single memory data input that has to be switched towards the selected column. The memory is able to operate in several erase modes: a single-memory-location erase mode, a row erase mode, a column erase mode and erase modes for erasing the whole memory matrix or a submatrix. Because of the global connection of the memory to said voltage terminal the erasure of a particular memory location and the programming of another particular memory location need to be separated in time and therefore need to be controlled by control circuitry outputting control signals in order to distinguish between a program mode or an erase mode.

In a memory circuit according to the invention as set forth in claim 1 only the data presented determines whether the selected memory location is to be erased or to be programmed. Each column has its own programming circuit controlled by the data fed to the respective data input, only the data discriminate between an erasure and a programming of a selected memory location. The programming means of a plurality of columns are addressable simultaneously by respective data simultaneously fed to the respective data inputs and simultaneous erasure and programming are allowed for various memory sections of a same row under data control. By employing latch means in each programming circuit, respective data are allowed to enter the memory circuit sequentially to be temporarily stored in the respective latches. After a full row of latches has received the data, the memory sections of a same row are activated in parallel, some of said sections undergoing an erasure others a programming, depending on the particular data.

In order to discriminate between data having the predetermined logical value and other data the detector gate means comprises a logic gate means having a gate input coupled to said data input and having a gate output coupled to a further latch means.

The invention will be described in detail hereinafter with reference to a drawing, in which
Figure 1 shows a schematic example of a memory circuit according to the invention;
Figure 2 shows the relevant parts of the level shifter for use in the first voltage generating means, and
Figure 3 shows the relevant parts of the second voltage generating means.

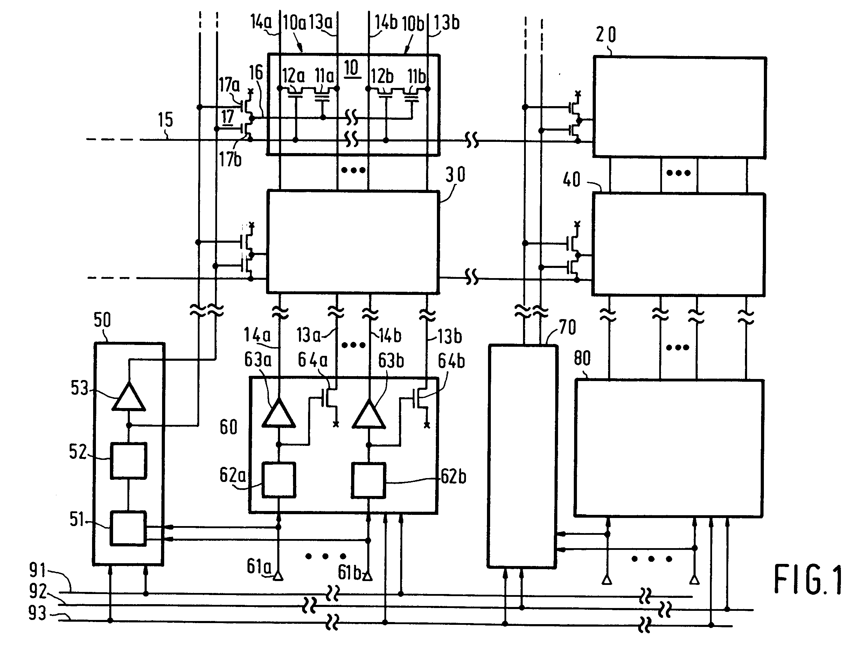

In Figure 1 there is shown by way of example a memory circuit according to the invention. Memory locations 10, 20, 30 and 40 form part of a memory matrix, which has not further been drawn for clarity, locations 10 and 20 being situated at a same row, locations 10 and 30 being situated at a same column. Only memory location 10 has been drawn in further detail for clarity. Each memory location comprises a plurality of bit cells 10a, ... 10b, each bit cell comprising a programmable transistor 11a, 11b having a floating gate and a selection transistor 12a, 12b, the conduction channels thereof being disposed in a series arrangement between a supply line 13a, 13b and a bit line 14a, 14b. Corresponding bit cells in the memory location 30 are connected in the same way to the corresponding bit-line-suppy-line-pair. Each bit cell 10a, 10b has two logic states. A first logic state which is denoted by a "1" and is represented by a charged floating gate. A second logic state is denoted by a "0" and is represented by a non-charged floating gate. Only the first logic state is actively programmed by forcing a tunnel current from the floating gate to the junction point of the selection transistor and the programmable transistor during a write cycle. This causes a charge at the floating gate and hence an enduring increase of the absolute value of the programmable transistor's threshold voltage. The bit cell is erased by forcing a tunnel current into the opposite direction. Within memory location 10, the control electrodes of the selection transistors 12a, 12b are connected to word line 15, that is common to the selection transistors of the memory locations disposed in the same row. The programmable transistors 11a, 11b of memory location 10 have their control electrodes connected to an activation line 16. Each individual memory location has been provided with such an activation line. The function of the supply lines 13a, 13b, bit lines 14a, 14b, activation line 16 and word line 15 with regard to the programming or erasure of memory location 10 will be described hereinafter.

Further, memory location 10 comprises a switch 17, having a first switch transistor 17a connected to the supply voltage and a second switch transistor 17b, a conduction channel thereof being disposed between word line 15 and activation line 16. Each memory location has been provided with an individual switch.

The second voltage generating means 50 controls switch 17, together with other switches of the memory locations located in the same column. The suppy lines 13a, 13b and bit lines 14a, 14b are controlled by the first voltage generating means 60. Each individual column has been provided with associated first voltage generating means 60, 80, and with second voltage generating means 50, 70.

In the example of Figure 1, the depicted transistors are supposed to be of the PMOS-field-effect type. In order to write a "1" into bit cell 10a, word line 15 has to be charged to a negative high voltage V_{EE}, activation line 16 has to be charged to a supply voltage V_{DD}, supply line 13a has to be floating for avoiding the occurrence of detrimentally high electrical fields in the programmable transistor 11a, and bit line 14a has to be charged to the negative high voltage V_{EE}. In order to erase all bit cells 10a, 10b in memory location 10 supply lines 13a, 13b and bit lines 14a, 14b have to be charged to supply voltage V_{DD}, and activation line 16 and word line 15 have to be charged to the negative high voltage V_{EE}. During a write cycle the logical contents of an already erased bit cell 10a is maintained if supply line 13a and bit line 14a are kept at the supply voltage V_{DD} while word line 15 and activation line 16 carry the negative high voltage V_{EE}.

The operation of the first voltage generating means 60 and the second voltage generating means 50 will now be described. As has been stated hereinabove, an erasure of a selected memory location occurs in case the data at the memory data input has a predetermined logic value, that is, in case the data presented at the first data input, that comprises terminals 61a, 61b, have a predetermined bit combination. In this example it is assumed that an erasure will be accomplished if all bits presented at the first data input will be a logic "0". In order to detect the occurrence of such combination the second voltage generating means comprises a NOR-gate 51.

It is further assumed that initially all bit cells 10a, 10b of memory location 10 have a logic "0" as logic content.
Now, at the first data input, a logic "1" is presented at terminal 61a and a logic "0" is presented at terminal 61b to be written into memory location 10. For the sake of clarity no other terminals or bit cells will be referred to. In order to write into memory location 10, the column, wherein memory location 10 is located, is selected via column selection line 91. Other columns connected to other column selection lines, like column selection line 92, do not receive a selection signal. After the relevant column is selected, the bits offered at the terminals 61a, 61b are loaded into the latches 62a, 62b, respectively, upon a load-latch signal at the load-latch signal line 93. Latch 62a now outputs a logic "1", that has a voltage equal to supply voltage V_{DD}, and latch 62b now outputs a logic "0", that is a voltage equal to ground, V_{SS}. The outputs of the latches 62a, 62b are connected to the inputs of level shifters 63a and 63b, respectively, and to control electrodes of supply transistors 64a and 64b, respectively. Level shifter 63a now charges bit line 14a to the negative high voltage V_{EE}, while the supply line 13a stays disconnected from supply voltage V_{DD} by the blocking of supply transistor 64a. Level shifter 63b charges bit line 14b to the supply voltage V_{DD}. Supply transistor 64b now conducts and the supply line 13b equally carries the supply voltage V_{DD}.
Because of the absence of the input data all being a logic "0", NOR-gate 51 outputs a logic "0" that upon the load-latch signal at load-latch signal line 93 is loaded into latch 52. As a consequence latch 52 outputs a voltage equal to ground, V_{SS}, and level shifter 53 outputs a voltage equal to the supply voltage V_{DD}. This causes in switch 17 the first switch transistor 17a to conduct and the second switch transistor 17b to block.
Thereupon a (not shown) row decoder charges word line 15 to the negative high voltage V_{EE}. The voltages now occurring on the respective lines force in programmable transistor 11a a tunnel current to charge the floating gate, while the uncharged state of the floating gate of programmable transistor 11b is maintained, as has been described hereinabove. After having been programmed in this manner, it is now assumed that all terminals 61a, ..., 61b of the first data input receive a logic "0" in order to erase memory location 10. This causes after selection of the relevant column and after occurrence of the load-latch signal the latches 62a, ..., 62b to be loaded with a logic "0", and latch 52 to be loaded with a logic "1" because of NOR-gate 51 outputting a logic "1". Thereupon level shifters 63a, ..., 63b output a voltage V_{DD} while supply transistors 64a, ..., 64b conduct. As a consequence the bit lines 14a, ..., 14b and the supply lines 13a, ..., 13b carry the supply voltage V_{DD}. Level shifter 53 now outputs the negative high voltage V_{EE}, as latch 52 outputs the supply voltage V_{DD}. In switch 17, the first switch transistor 17a then blocks while the second switch transistor 17b connects activation line 16 to word line 15, the latter now being charged by a (not shown) row decoder to the negative high voltage V_{EE}. Consequently, each bit cell 10a, ..., 10b of memory location 10 now is forced to comprise a logic "0" as a logic content. For the sake of clarity, the read means have been omitted from the drawing, which read means comprises a sense amplifier for each bit line. It is noted that the input terminals such as 61a, ..., 61b of several columns may be connected to a same data input bus. By way of sequentially selecting the relevant column the respective latches belonging to several columns may be loaded. Applying the high voltage thereafter enables a whole row of the memory to be written at once, some locations thereby undergoing an erasure, others a write operation, depending on the loaded data.

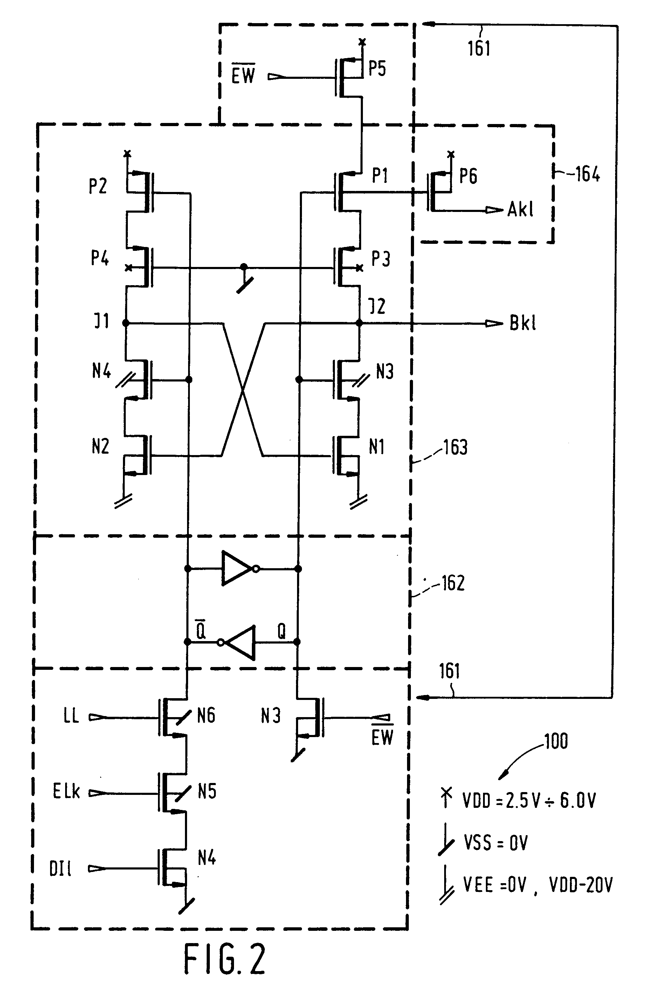

In Figure 2 the relevant parts of the level shifter and the associated latch for use in the first voltage generating means are depicted. The shown circuit comprises control logic circuitry 161, a latch 162, level shifter 163 and supply transistor 164. In legend 100 the signs are shown to indicate the relevant voltages present in the circuit.

The control logic circuitry 161 comprises: a NMOS-transistor N4, a control electrode of which is connected to a terminal of the first data input for receiving a relevant data-bit DIₗ; a NMOS-transistor N5, a control electrode of which is connected to an associated column selection line (lines 91 or 92 in Figure 1) for receiving the column selection signal ELₖ; a NMOS-transistor N6, a control electrode of which is connected to the load-latch line (line 93 in Figure 1) for receiving the load latch signal LL; a NMOS-transistor N3 and a PMOS-transistor P5 for receiving the write-enable signal E̅W̅ transmitted by a not further described write enable circuit.

The level shifter 163 comprises a first current path between supply voltage V_{DD} and the negative high voltage V_{EE}, constituted by the series arrangement of the conduction channels of PMOS-transistors P2, P4 and of the NMOS-transistors N4 and N2, and a second current path between supply terminal V_{DD} and the negative high voltage V_{EE}, constituted by the conduction channels of PMOS-transistors P1, P3 and NMOS-transistors N3, N1. A node J1 between transistors P4 and N4 is connected to the control electrode transistor N1; a node J2 between transistors P3 and N3 is connected to the control electrode of transistor N2. The transistors P3, N3, P4, N4 have been inserted as a protection for transistors P1, N1, P2, N2 against detrimentally high electrical fields. Transistors P1, N1 and N3 on the one hand and transistors P2, N2 and N4 on the other hand are mutually complementary controlled by the control logic circuitry 161 and the latch 162 disposed between the control logic circuitry 161 and level shifter 163. It is assumed that signal E̅W̅ has been logic "1" formerly so that the present initial state of latch 162 is such that output Q is logic "0", and output Q̅ is logic "1". Consequently, signal E̅W̅ being returned to logic "0", the voltage at node J1 equals V_{EE} and the voltage at node J2 equals VDD. When signals LL, ELₖ and DIₗ are all logic "1", latch 162 is set to output a logic "0" at Q̅ and a logic "1" at Q. The logic "1" at Q causes transistor P1 to block and the logic "0" at Q̅ causes transistor P2 to conduct. The voltage at node J1 then slightly increases, whereupon transistor N1 will start to conduct, thereby lowering the voltage at node J2, as a consequence whereof transistor N2 will conduct less current. This process will cease in the event of node 32 being at V_{EE} and node J1 being at V_{DD}. Since terminal Q of latch 162 also controls supply transistor P6, which connects the supply line Aₖₗ, e.g. 13a in Figure 1, to the supply voltage V_{DD}, said supply transistor P6 will be blocked when terminal Q carries the logic "1", thereby rendering the supply line Aₖₗ floating. The bitline Bₖₗ, e.g. 14a in Figure 1, is connected to node J2 and now carries the negatieve high voltage V_{EE}. Under these conditions a logic "1" will be written in the relevant bitcel of the selected memory location, e.g. bit cell 10a of memory location 10 of Figure 1. In case a logic "0" is present at the control electrode transistor N4 the latch 162 is not set. Terminal Q of latch 162 then will maintain its logic "0". The voltages at nodes J1 and J2 will then be kept at V_{EE} and V_{DD}, respectively, and supply transistor P6 will be maintained in the conducting state. Under these conditions the relevant erased bit cell connected to supply line Aₖₗ and bitline Bₖₗ will maintain its logic "0" state. To complete the above picture a sense amplifier (not shown), used in the reading mode of the circuit (E̅W̅=1), may be connected between transistors P5 and P1.

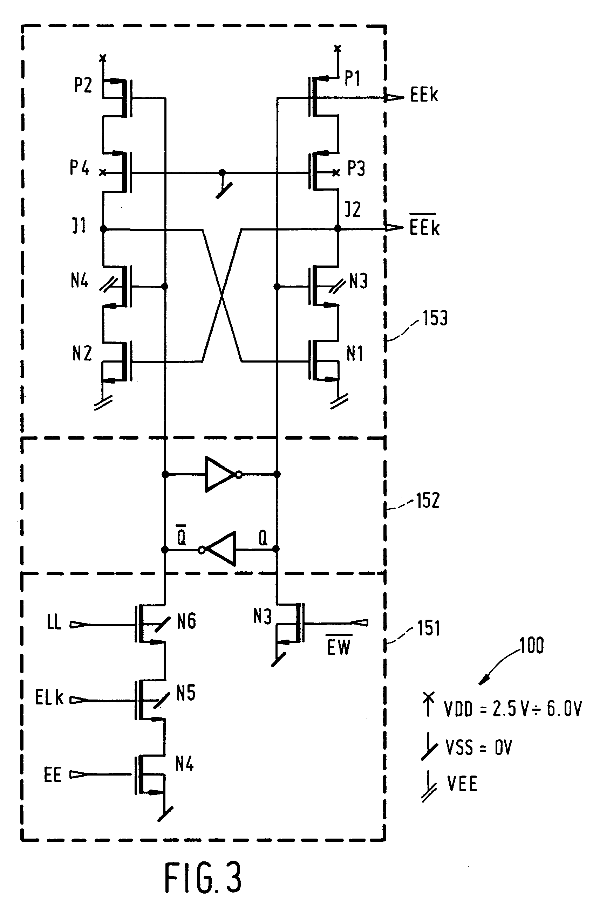

In Figure 3 the relevant parts of the second voltage generating means are shown. The reference numerals in Figure 3 designate the parts and components corresponding to or identical to those of the previous Figure 2. The operation is similar to that of the circuit shown in Figure 2. The depicted second voltage generating means comprises control logic circuitry 151, a latch 152 and a level shifter 153. The control electrode of transistor N4 is connected to the output of a NOR-gate (not shown), that receives the respective bits to be written into the respective bit cells of the selected memory location. Unless all bits are logic "0" the latch will not be set and will output a logic "0" at Q and a logic "1" at Q̅. As a consequence, node J2 will carry signal E̅E̅ₖ being a logic "1" at supply voltage level V_{DD}, thereby blocking the second switching transistor in the switch accompanying the relevant memory location, e.g. transistor 17b in switch 17 of memory location 10 in Figure 1. Output Q of latch 152 is connected to the first switch transistor in said switch (transistor 17a in switch 17) and will render said transistor conductive by signal EEₖ being equal to V_{SS}. As a consequence the activation line (activation line 16) will be kept at V_{DD} and no erasure will occur.
In case all data bits received by the NOR-gate are logic "0" the latch is set to output a logic "1" at Q and a logic "0" at Q̅.
Consequently signal E̅E̅ₖ is at V_{EE} switching the second switch transistor (e.g. switch transistor 17b in Figure 1) on, while signal EEₖ is at V_{DD} thereby blocking the first switching transistor (e.g. switching transistor 17a).

It may be noted that the latches 152 and 162 not only function as elements having a memory function, but also as to output mutually complementary signals in order to control the parallel current paths in the relevant level shifter 153 and 163, respectively. The arrangement of the control logic circuitry, the latch and the level shifter in the way shown, offers a very compact building block for a memory of the kind set forth.

## Claims

1. An integrated memory circuit with an EEPROM having a plurality of sections (10/30/50/60; 20/40/70/80), each particular one of the sections comprising:
- a plurality of rows of memory cells (10a; 10b) arranged in a plurality of columns; and
- programming means (50/60) to program selected ones of the memory cells under control of a plurality of respective data supplied in parallel to a plurality of respective data input nodes (61a; 61b);
wherein:
- each respective one of the columns comprises a respective first control line (14a; 14b) and a respective second control line (13a; 13b);
- each memory cell of the respective column is coupled between the respective first and second control lines;
- each memory cell includes a programmable transistor (11a; 11b) and an access transistor (12a; 12b) with conduction channels arranged in series;
- control electrodes of the access transistors of a respective one of the rows are coupled to a respective word line (15);
**characterized in that**:
- in each cell of the respective column, the access transistor has its conduction channel coupled to the respective first control line and the programmable transistor has its conduction channel coupled to the respective second control line;
- the programming means of the particular section comprises:
- a plurality of uniform programming circuits, a respective one for each respective column, each programming circuit comprising:
- a respective level shifter (63a; 63b) having an input coupled to a respective one of the data input nodes and having an output connected to the first control line and being operative to supply either a high-level programming voltage (V_{EE)} or a low-level supply voltage (V_{DD}) under control of the respective data;
- first switch means (64a; 64b) being arranged between a supply terminal (V_{DD}) and the second control line and being operative to connect the second control line to the supply voltage under control of the respective data at the respective data input node;
- a detector gate means (50) having a detector input connected to the data input nodes of the section and being operative to furnish an output signal indicative of a predetermined logic level of the data present at the data input nodes;
- a plurality of second switch means (17), one for each row in the section, for supplying the control electrodes of the programmable transistors with either the high-level programming voltage at the presence of the predetermined logic level of the data or the supply voltage under control of the detector gate means.

2. The circuit of claim 1, characterized in that the detector gate means is operative to furnish the output signal if the plurality of data of predetermined logic level all have the same logic level.

3. The circuit of claim 1, characterized in that the programming means of the plurality of sections can be activated in parallel.

4. The circuit of claim 1, characterized in that each respective data input node is coupled to the respective level shifter via a respective latch (62a; 62b; 162).

5. The circuit of claim 4, characterized in that the respective level shifter comprises:
- a first current path with a conduction channel of a first transistor (P2) connected to the supply voltage and with a conduction channel of a second transistor (N2) connected to the programming voltage;
- a second current path with a conduction channel of a third transistor (P1) coupled to the supply voltage and with a conduction channel of a fourth transistor (N1) connected to the programming voltage;
wherein:
- a first node (J1) between the first and second transistors is coupled to a control electrode of the fourth transistor;
- a second node (J2) between the third and fourth transistors is coupled to a control electrode of the second transistor;
- control electrodes of the first and third transistors are coupled to the respective data input node via the latch (62a; 162) for mutually complementary control;
- a fifth transistor (64a; P6) is arranged between the supply voltage terminal and the second control line (13a; Akl);
- the second node is connected to the first control line (14a; Bkl);
- the first, third and fifth transistors are of a first conductivity type;
- the second and fourth transistors are of a second conductivity type.

6. The circuit of claim 1, wherein the detector gate means comprises:
- a logic gate (51) having a plurality of respective gate inputs connected to the respective data input nodes;
- a further level shifter (53) having an input coupled to an output of the logic gate; and wherein the second switch means comprises:
- an upper switch (17a) being arranged between the supply voltage terminal and a node (16) connected to the control electrodes of the programmable transistors and controllably coupled to the output of the further level shifter; and
- a lower switch (17b) being arranged between said node and the word line and being controllably coupled to the output of the logic gate.

7. The circuit of claim 6, wherein the logic gate is coupled to the further level shifter via a latch (52).

8. The circuit of claim 7, wherein the further level shifter comprises:
- a first current path with a conduction channel of a first transistor (P2) connected to the supply voltage and with a conduction channel of a second transistor (N2) connected to the programming voltage;
- a second current path with a conduction channel of a third transistor (P1) coupled to the supply voltage and with a conduction channel of a fourth transistor (N1) connected to the programming voltage;
wherein:
- a first node (J1) between the first and second transistors is coupled to a control electrode of the fourth transistor;
- a second node (J2) between the third and fourth transistors is coupled to a control electrode of the second transistor;
- control electrodes of the first and third transistors are coupled to the latch (52; 152) for mutually complementary control;
- the control electrode of the third transistor is connected to control the upper switch (17a);
- the second node is connected to control the lower switch (17b);
- the first and third transistors are of a first conductivity type; and
- the second and fourth transistors are of a second conductivity type.

## Patentansprüche

1. Integrierte Speicherschaltung mit einem EEPROM mit einer Vielzahl von Abschnitten (10/30/50/60; 20/40/70/80), wobei jeder einzelne Abschnitt folgendes enthält:
- eine Vielzahl von Reihen, von Speicherzellen (10a; 10b), die in einer Vielzahl von Spalten angeordnet sind; und
- ein Programmier-Mittel (50/60) zum Programmieren von ausgewählten Speicherzellen unter der Steuerung einer Vielzahl von entsprechenden Daten, die parallel einer Vielzahl von entsprechenden Dateneingangsknotenpunkten (61a; 61b) zugeführt werden;
wobei
- jede betreffende Spalte eine entsprechende erste Steuerleitung (14a; 14b) und eine entsprechende zweite Steuerleitung (13a; 13b) enthält;
- jede Speicherzelle der betreffenden Spalte zwischen die entsprechende erste und die zweite Steuerleitung geschaltet ist;
- jede Speicherzelle einen programmierbaren Transistor (11a; 11b) und einen Zugriffstransistor (12a; 12b) mit in Reihe angeordneten Leitungskänalen umfaßt;
- die Steuerelektroden der Zugriffstransistoren einer betreffenden Reihe mit einer entsprechenden Wortleitung (15) verbunden sind;
dadurch gekennzeichnet, daß:
- in jeder Zelle der entsprechenden Spalte der Leitungskanal des Zugriffstransistors mit der entsprechenden ersten Steuerleitung verbunden ist und der Leitungskanal des programmierbaren Transistors mit der entsprechenden zweiten Steuerleitung verbunden ist;
- das Programmier-Mittel des betreffenden Abschnittes folgendes enthält:
- eine Vielzahl von gleichförmigen Programmierschaltungen, jeweils eine für jede entsprechende Spalte, wobei jede Programmierschaltung folgendes umfaßt:
- einen entsprechenden Pegelverschieber (63a; 63b), dessen Eingang mit einem entsprechenden ersten der Dateneingangsknotenpunkte verbunden ist und dessen Ausgang mit der ersten Steuerleitung verbunden ist und der dazu dient, entweder eine hohe Programmierspannung (V_{EE}) oder eine niedrige Versorgungsspannung (V_{DD}) unter der Steuerung der entsprechenden Daten zu liefern;
- ein erstes Schaltmittel (64a; 64b), das zwischen einem Versorgungsanschluß (V_{DD}) und der zweiten Steuerleitung angeordnet ist und dazu dient, unter der Steuerung der entsprechenden Daten an dem entsprechenden Dateneingangsknotenpunkt die zweite Steuerleitung mit der Versorgungsspannung zu verbinden;
- ein Detektorgatter-Mittel (50) mit einem Detektoreingang, der mit den Dateneingangsknotenpunkten des Abschnittes verbunden ist und das dazu dient, ein Ausgangssignal zu liefern, das einen vorgegebenen Logikpegel der an den Dateneingangsknotenpunkten anliegenden Daten angibt;
- eine Vielzahl von zweiten Schaltmitteln (17), eines für jede Reihe in dem Abschnitt, um den Steuerelektroden der programmierbaren Transistoren unter der Steuerung des Detektorgatter-Mittels entweder eine hohe Programmierspannung bei Vorhandensein des vorgegebenen Logikpegels der Daten oder eine Versorgungsspannung zuzuführen.

2. Schaltung nach Anspruch 1, dadurch gekennzeichnet, daß das Detektorgatter-Mittel dazu dient, das Ausgangssignal zu liefern, wenn die Daten mit dem vorgegebenen Logikpegel alle den gleichen Logikpegel haben.

3. Schaltung nach Anspruch 1, dadurch gekennzeichnet, daß die Programmiermittel aller Abschnitte parallel aktiviert werden können.

4. Schaltung nach Anspruch 1, dadurch gekennzeichnet, daß jeder entsprechende Dateneingangsknotenpunkt über einen entsprechenden selbsthaltenden Schalter (62a; 62b; 162) mit dem entsprechenden Pegelverschieber verbunden ist.

5. Schaltung nach Anspruch 4, dadurch gekennzeichnet, daß der entsprechende Pegelverschieber folgendes umfaßt:
- einen ersten Strompfad mit einem Leitungskanal eines ersten Transistors (P2), der mit der Versorgungsspannung verbunden ist, und mit einem Leitungskanal eines zweiten Transistors (N2), der mit der Programmierspannung verbunden ist;
- einen zweiten Strompfad mit einem Leitungskanal eines dritten Transistors (P1), der mit der Versorgungsspannung verbunden ist, und mit einem Leitungskanal eines vierten Transistors (N1), der mit der Programmierspannung verbunden ist;
wobei:
- ein erster Knotenpunkt (J1) zwischen dem ersten und dem zweiten Transistor mit einer Steuerelektrode des vierten Transistors verbunden ist;
- ein zweiter Knotenpunkt (J2) zwischen dem dritten und dem vierten Transistor mit einer Steuerelektrode des zweiten Transistors verbunden ist;
- die Steuerelektroden des ersten und des dritten Transistors über den selbsthaltenden Schalter (61a; 162) zur wechselseitigen komplementären Steuerung mit dem jeweiligen Dateneingangsknotenpunkt verbunden sind;
- ein fünfter Transistor (64a; P6) zwischen dem Versorgungsspannungsanschluß und der zweiten Steuerleitung (13a; Aₖₗ) angeordnet ist;
- der zweite Knotenpunkt mit der ersten Steuerleitung (14a; Bₖₗ) verbunden ist;
- der erste, dritte und fünfte Transistor von einem ersten Leitfähigkeitstyp sind;
- der zweite und der vierte Transistor von einem zweiten Leitfähigkeitstyp sind.

6. Schaltung nach Anspruch 1, wobei das Detektorgatter-Mittel folgendes enthält:
- ein Logikgatter (51) mit einer Vielzahl von entsprechenden Gattereingängen, die mit den jeweiligen Dateneingangsknotenpunkten verbunden sind;
- einen weiteren Pegelverschieber (53), dessen Eingang mit einem Ausgang des Logikgatters verbunden ist, und wobei das zweite Schaltmittel folgendes enthält:
- einen oberen Schalter (17a), der zwischen dem Versorgungsspannungsanschluß und einem Knotenpunkt (16), der mit den Steuerelektroden der programmierbaren Transistoren verbunden ist, angeordnet ist und der steuerbar mit dem Ausgang des weiteren Pegelverschiebers verbunden ist, und
- einen unteren Schalter (17b), der zwischen dem genannten Knotenpunkt und der Wortleitung angeordnet ist und steuerbar mit dem Ausgang des Logikgatters verbunden ist.

7. Schaltung nach Anspruch 6, wobei das Logikgatter über einen selbsthaltenden Schalter (52) mit dem weiteren Pegelverschieber verbunden ist.

8. Schaltung nach Anspruch 7, wobei der weitere Pegelverschieber folgendes enthält:
- einen ersten Strompfad mit einem Leitungskanal eines ersten Transistors (P2), der mit der Versorgungsspannung verbunden ist, und mit einem Leitungskanal eines zweiten Transistors (N2), der mit der Programmierspannung verbunden ist;
- einen zweiten Strompfad mit einem Leitungskanal eines dritten Transistors (P1), der mit der Versorgungsspannung verbunden ist, und mit einem Leitungskanal eines vierten Transistors (N1), der mit der Programmierspannung verbunden ist;
wobei:
- ein erster Knotenpunkt (J1) zwischen dem ersten und dem zweiten Transistor mit einer Steuerelektrode des vierten Transistors verbunden ist;
- ein zweiter Knotenpunkt (J2) zwischen dem dritten und dem vierten Transistor mit einer Steuerelektrode des zweiten Transistors verbunden ist;
- die Steuerelektroden des ersten und des dritten Transistors mit dem selbsthaltenden Schalter (52; 152) zur wechselseitigen komplementären Steuerung verbunden sind;
- die Steuerelektrode des dritten Transistors angeschlossen ist, um den oberen Schalter (17a) zu steuern;
- der zweite Knotenpunkt angeschlossen ist, um den unteren Schalter (17b) zu steuern;
- der erste und der dritte Transistor von einem ersten Leitfähigkeitstyp sind und
- der zweite und der vierte Transistor von einem zweiten Leitfähigkeitstyp sind.

## Revendications

1. Circuit de mémoire intégré comprenant une mémoire EEPROM comportant une pluralité de sections (10/30/50/60; 20/40/70/80), chaque section particulière desdites sections comprenant :
- une pluralité de lignes de cellules de mémoire (10a; 10b) agencées en une pluralité de colonnes, et
- des moyens de programmation (50/60) dur programmer des cellules sélectionnées parmis lesdites cellules de mémoire sous la commande d'une pluralité de données respectives délivrées en parallèle à une pluralité de noeuds d'entrée de données respectifs (61a, 61b); circuit dans lequel :
- chaque colonne respective desdites colonnes comprend une première ligne de commande respective (14a; 14b) et une deuxième ligne de commande respective (13a; 13b);
- chaque cellule de mémoire de la colonne respective est couplée entre la première ligne et la deuxième ligne de commande respectives;
- chaque cellule de mémoire comprend un transistor programmable (11a; 11b) et un transistor d'accès (12a; 12b) avec des canaux de conduction agencés en série;
- des électrodes de commande des transistors d'accès d'une ligne respective parmis lesdites lignes sont couplées à une ligne de mots respective (15);
caractérisé en ce que :
- dans chaque cellule de la colonne respective, le transistor d'accès a son canal de conduction couplé à la première ligne de commande respective et le transistor programmable a son canal de conduction couplé à la deuxième ligne de commande respective;
- les moyens de programmation de la section particulière comprennent :
- une pluralité de circuits de programmation uniformes, à raison d'un respectivement pour chaque colonne, chaque circuit de programmation comprenant :
- un décaleur de niveau respectif (63a; 63b) ayant une entrée couplée à un noeud respectif desdits noeuds d'entrée de données et ayant une sortie connectée à la première ligne de commande et étant à même de fournir soit une tension de programmation de haut niveau (V_{EE}), soit une tension d'alimentation de bas niveau (V_{DD}) sous la commande des données respectives;
- un premier moyen de commutation (64a; 64b) étant agencé entre une borne d'alimentation (V_{DD}) et la deuxième ligne de commande et étant à même de connecter la deuxième ligne de commande à la tension d'alimentation sous la commande des données respectives au noeud d'entrée de données respectif;
- un moyen de détection à porte (50) ayant une entrée de détection connectée aux noeuds d'entrée de données de la section et étant à même de fournir un signal de sortie indiquant un niveau logique prédéterminé des données présentes aux noeuds d'entrée de données;
- une pluralité de deuxièmes moyens de commutation (17), un pour chaque ligne de la section, pour alimenter les électrodes de commande des transistors programmables avec soit la tension de programmation de haut niveau en présence du niveau logique prédéterminé des données, soit la tension d'alimentation sous la commande du moyen de détection à porte.

2. Circuit selon la revendication 1, caractérisé en ce que le moyen de détection à porte est à même de fournir le signal de sortie si la pluralité de données de niveau logique prédéterminé ont toutes le même niveau logique.

3. Circuit selon la revendication 1, caractérisé en ce que les moyens de programmation de la pluralité de sections peuvent être activés en parallèle.

4. Circuit selon la revendication 1, caractérisé en ce que chaque noeud d'entrée de données respectif est couplé au décaleur de niveau respectif via un verrou respectif (62a; 62b; 162).

5. Circuit selon la revendication 4, caractérisé en ce que le décaleur de niveau respectif comprend :
- un premier trajet de courant avec un canal de conduction d'un premier transistor (P2) connecté à la tension d'alimentation et avec un canal de conduction d'un deuxième transistor (N2) connecté à la tension de programmation;
- un deuxième trajet de courant avec un canal de conduction d'un troisième transistor (P1) couplé à la tension d'alimentation et avec un canal de conduction d'un quatrième transistor (N1) connecté à la tension de programmation;
circuit dans lequel :
- un premier noeud (J1) entre le premier transistor et le deuxième transistor est couplé à une électrode de commande du quatrième transistor;
- un deuxième noeud (J2) entre le troisième transistor et le quatrième transistor est couplé à une électrode de commande du deuxième transistor;
- des électrodes de commande du premier transistor et du troisième transistor sont couplées au noeud d'entrée de données respectif via le verrou (62a; 162) pour une commande mutuellement complémentaire;
- un cinquième transistor (64a, P6) est agencé entre la borne de tension d'alimentation et la deuxième ligne de commande (13a; Aₖₗ);
- le deuxième noeud est connecté à la première ligne de commande (14a; Bₖₗ);
- le premier transistor, le troisième transistor et le cinquième transistor sont d'un premier type de conductivité;
- le deuxième transistor et le quatrième transistor sont d'un deuxième type de conductivité.

6. Circuit selon la revendication 1, dans lequel le moyen de détection à porte comprend :
- une porte logique (51) comportant une pluralité d'entrées respectives connectées aux noeuds d'entrée de données respectifs;
- un autre décaleur de niveau (53) ayant une entrée couplée à une sortie de la grille logique, et dans lequel le deuxième moyen de commutation comprend :
- un commutateur supérieur (17a) agencé entre la borne de tension d'alimentation et un noeud (16) connecté aux électrodes de commande des transistors programmables et couplé de manière contrôlable à la sortie de l'autre décaleur de niveau, et
- un commutateur inférieur (17b) agencé entre ledit noeud et la ligne de mots et qui est couplé de manière contrôlable à la sortie de la porte logique.

7. Circuit selon la revendication 6, dans lequel la porte logique est couplée à l'autre décaleur de niveau via un verrou (52).

8. Circuit selon la revendication 7, dans lequel l'autre décaleur de niveau comprend :
- un premier trajet de courant avec un canal de conduction d'un premier transistor (P2) connecté à la tension d'alimentation et avec un canal de conduction d'un deuxième transistor (N2) connecté à la tension de programmation;
- un deuxième trajet de courant avec un canal de conduction d'un troisième transistor (P1) couplé à la tension d'alimentation et avec un canal de conduction d'un quatrième transistor (N1) connecté à la tension de programmation;
circuit dans lequel :
- un premier noeud (J1) entre le premier transistor et le deuxième transistor est couplé à une électrode de commande du quatrième transistor;
- un deuxième noeud (J2) entre le troisième transistor et le quatrième transistor est couplé à une électrode de commande du deuxième transistor;
- les électrodes de commande du premier transistor et du troisième transistor sont couplées au verrou (52; 152) pour une commande mutuellement complémentaire;
- l'électrode de commande du troisième transistor est connectée pour commander le commutateur supérieur (17a);
- le deuxième noeud est connecté pour commander le commutateur inférieur (17b);
- le premier transistor et le troisième transistor sont d'un premier type de conductivité, et
- le deuxième transistor et le quatrième transistor sont d'un deuxième type de conductivité.
